# EUROPÄISCHE PATENTSCHRIFT

(11) **EP 0 794 571 B1**
(45) Veröffentlichungstag und Bekanntmachung des Hinweises auf die Patenterteilung: **05.09.2001**
(21) Anmeldenummer: 97103078.8
(22) Anmeldetag: 26.02.1997
(51) Int. Cl.: H01L 23/495

(54) **Vorgestanztes Metallrahmenband zur Herstellung von elektronischen Bauelementen**
Prepunched leadframe for making electronic components
Bande métallique prédécoupée pour la fabrication de composants électroniques

(30) Priorität: 06.03.1996 FR 9602998
(43) Veröffentlichungstag der Anmeldung: 10.09.1997
(73) Patentinhaber: General Semiconductor Ireland, Macroom, County Cork (IE)
(72) Erfinder: Pascuttini, Umberto, 68230 Turckheim (FR)
(74) Vertreter: Menges, Rolf, Dipl.-Ing.

(56) Entgegenhaltungen:
- EP-A- 0 001 892
- US-A- 4 616 250
- US-A- 4 994 412
- US-A- 5 343 072
- PATENT ABSTRACTS OF JAPAN Bd. 11, Nr. 22 (E-522) & JP 62 035 549 A (MITSUBISHI ELECTRIC CORP) 16 Februar 1987

## Beschreibung

Die vorliegende Erfindung betrifft ein vorgestanztes Metallrahmenband, ein Verfahren zum Herstellen von elektronischen Bauelementen mit Halbleiterkristallen und ein elektronisches Bauelement mit Halbleiterkristall gemäß den Oberbegriffen der Patentansprüche. 1,6 bzw 8.

Gegenwärtig gibt es im wesentlichen drei technische Verfahren zum Herstellen von elektronischen Bauelementen der genannten Art, deren Charakteristiken im folgenden beschrieben werden.

Das erste technische Herstellungsverfahren verwendet ein vorgestanztes Metallrahmenband (oder in der englischen Sprache "frame"), das zwei seitlich durchgehende Aufbaustreifen und Zungen umfaßt, die zwischen den genannten Streifen verlaufen und paarweise angeordnet sind, wobei jedes Teil jedes Paares ausgehend von einem seitlichen Aufbaustreifen in die Richtung des gegenüberliegenden Aufbaustreifens verläuft und die Zungen jedes Paares einander gegenüberliegen.

Das besagte vorgestanzte Band wird längs so positioniert, daß jedes Zungenpaar auf die Höhe seiner Herstellungsstation gebracht wird.

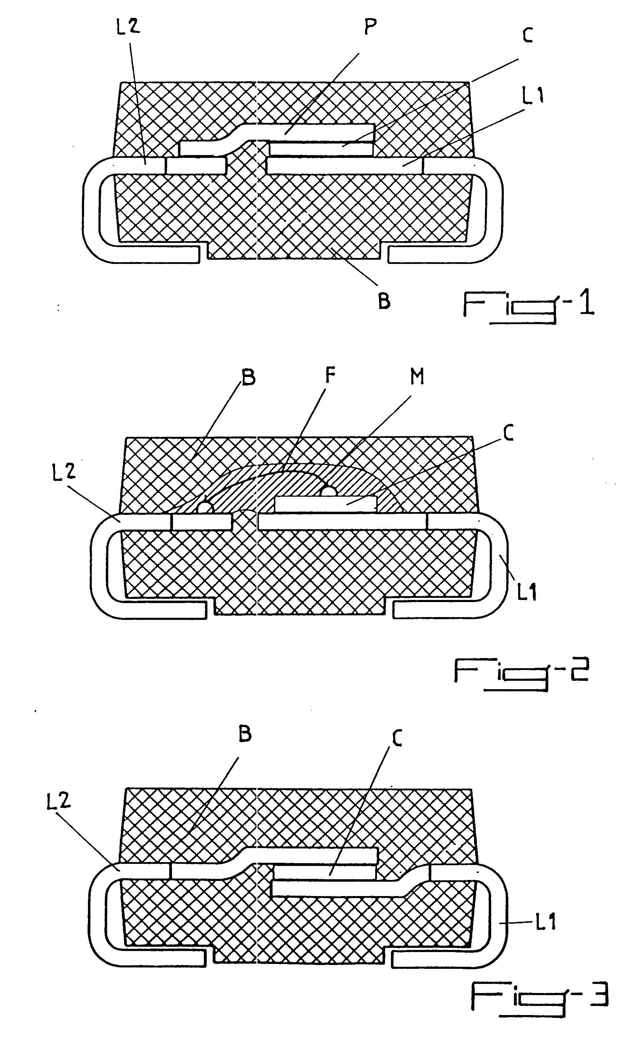

Am Ende einer der Zungen L1 wird der Halbleiterkristall C befestigt, und es wird ein separates Verbindungsteil P aufgesetzt und mit einem Bindemittel befestigt, um die elektrische Verbindung zwischen dem Kristall C und der anderen Zunge L2 zu bewirken (Fig. 1).

Das Schutzgehäuse B wird anschließend angeformt, und die Zungen werden abgeschnitten, und die Anschlußfahnen werden durch Formen gebildet.

Dieses Herstellungsverfahren resultiert in drei internen Verbindungsstellen, was die Zuverlässigkeit des Bauelements stark beeinträchtigt und komplizierte Montageeinrichtungen und langsame Arbeitstakte erforderlich macht und die Investitionen und die Wartungskosten in die Höhe treibt.

Darüber hinaus ist die Selbsthaltung der Anordnung aus den Zungen, dem Kristall und dem Verbindungsteil vor der Verfestigung des Bindemittels ein für die Endqualität des Bauelements wesentlicher Arbeitsvorgang, der allerdings immer kritisch und schwierig in zuverlässiger Weise steuerbar ist.

Im übrigen begrenzt oder verbietet die geringe Genauigkeit der Montage sogar die Anwendung dieses technischen Verfahrens zur Verwirklichung von Bauelementen vom planaren Typ oder von einem Typ, der einen Kristall umfaßt, der mit einem Ansatz versehen ist, der eine vorhergehende mechanische Ausrichtung erlaubt.

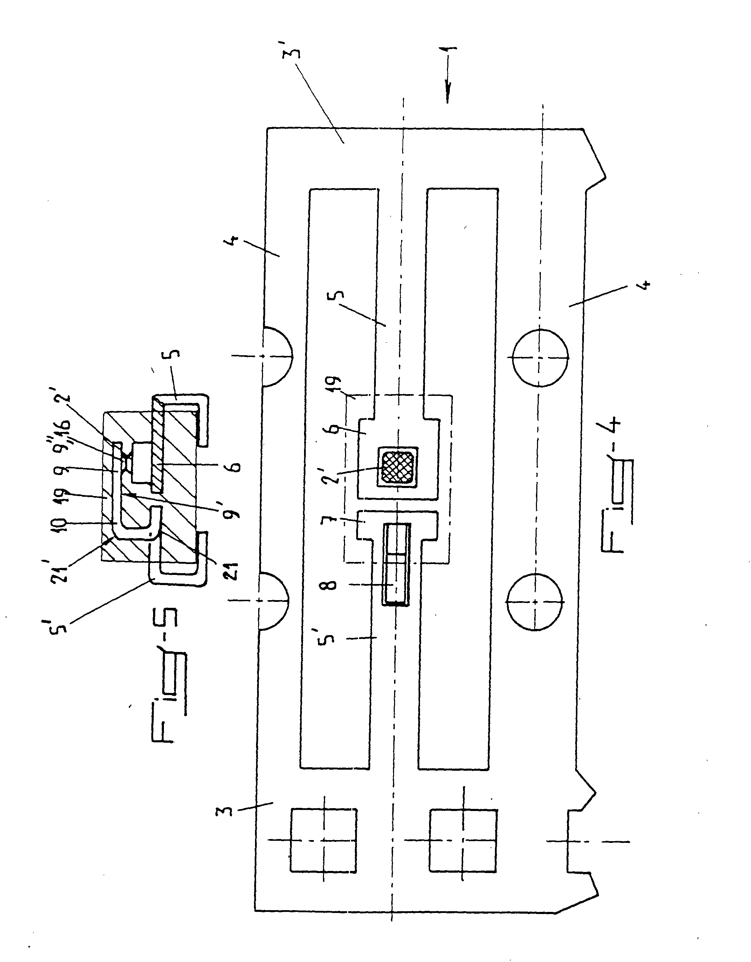

Das zweite bekannte technische Herstellungsverfahren besteht darin, daß von einem vorgestanzten Rahmenband ausgegangen wird, das mit demjenigen identisch ist, das bei dem ersten genannten Verfahren verwandt wird, an einem Ende einer Zunge L1 eines Zungenpaares L1, L2 ein Halbleiterkristall C befestigt wird, danach eine Verbindung über einen Edelmetalldraht F zwischen dem besagten Kristall C und der anderen Zunge L2 hergestellt wird, dann der Verbindungsdraht F durch Aufbringen eines polymerisierbaren Pulvers M abgeschirmt wird, und schließlich das Schutzgehäuse B angeformt wird, die Zungen L1, L2 abgeschnitten werden und die Anschlußfahnen geformt werden (Fig. 2).

Dieses zweite technische Herstellungsverfahren macht indessen außerordentlich kostenspielige Materialien erforderlich, resultiert gleichfalls in drei Verbindungspunkten und erlaubt es aufgrund der Begrenzng des zulässigen Querschnittes der Verbindungsdrähte, nur Bauteile mit relativ geringer Leistung zu erzeugen.

Dieses technische Verfahren benötigt weiterhin kostenträchtige Anlagen, nur mittlere Arbeitstaktfolgen und ausgeklügelte Techniken, die ein Wartungspersonal mit hoher Qualifikation erforderlich machen.

Im übrigen ist die Anordnung der Schutzschicht aus einem polymerisierbaren Pulver M ein schwieriger und kritische Arbeitsvorgang, von dem direkt die Qualität des fertigen Bauelements abhängt, und der mit der Gefahr verbunden ist, daß durch ein Aufbringen des Pulvers über den zu schützenden Bereich hinaus die Form beschädigt wird, die zum Formen des Gehäuses B benutzt wird.

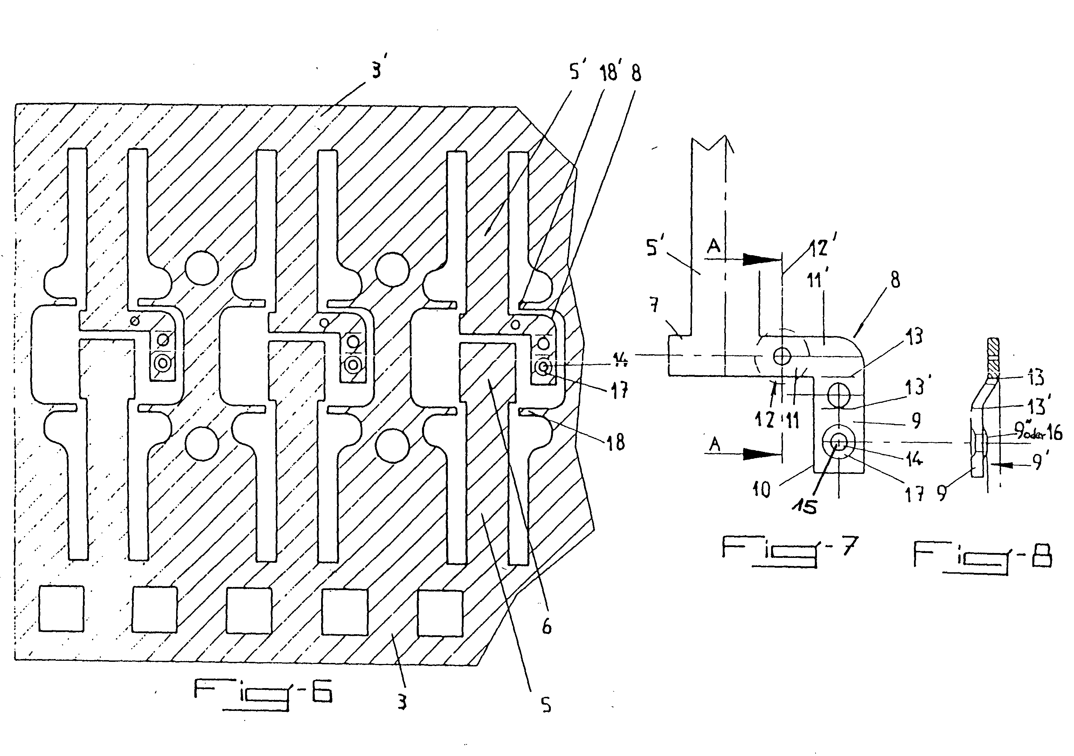

Das dritte technische Herstellungsverfahren besteht darin, daß die Verbindungsstellen der Bauelemente dadurch realisiert werden, daß mit dazwischen angeordneten Halbleiterkristallen C die Enden c.er Zungen L1 und L2 miteinander verbunden werden, die in zwei Teilen unabhängiger Bänder ausgestanzt sind, die so angeordnet werden, daß diese Enden der Zungen L1 und L2 einander paarweise übergreifen, danach das Gehäuse B angegossen wird und die Verbindungsfahnen geformt werden (Fig. 3).

Dieses dritte technische Verfahren hat gleichfalls eine Anzahl von Mängeln. Es erlaubt nämlich keine kontinuierliche Herstellung, da die ausgestanzten Teile der Bänder mit verschiedenen Geometrien notwendigerweise eine geringe Länge haben und nicht in Wickeln aufgerollt werden konnen.

Die Montage mit Bauteilen begrenzter Länge macht einerseits Bevorratungs- und Lagereinrichtungen sowie spezielle Werkzeuge erforderlich, was keine Anpassungsfähigkeit erlaubt, und begrenzt andererseits die Anzahl an Bauelementen, die gleichzeitig montiert werden, was zu nicht sehr großen Arbeitstaktfolgen führt.

Im übrigen setzt die Montage von vielen unabhängigen Bauteilen aus nicht festen Segmenten die Montagegenauigkeit herab, sie neigt dazu, den Arbeitsvorgang des Anformens des Gehäuses unsicher zu machen.

In Hinblick darauf, die genannten Mängel zu beheben, ist beispielsweise in der Druckschrift JP-A-62035549 (die zur Bildung der Oberbegriffe der Patentansprüche 1,6 und 8 herangezogen worden ist) bereits ein Verfahren zum Herstellen von elektronischen Bauelementen mit Halbleiterkristallen vorgeschlagen worden, bei dem die beiden Metallzungen, die für jedes Bauelement einerseits die Selbsthalteteile und die interne Verbindung des Kristalls und andererseits die äußeren Anschlußzungen des Bauelements bilden, im selben Metallband ausgestanzt werden.

Das Ausstanzen erfolgt derart, daß die Zungen in Paaren angeordnet sind, in denen jedes Bauteil ausgehend von einem durchgehenden seitlichen Aufbaustreifen in die Richtung auf den gegenüberliegenden Aufbaustreifen verläuft, der die andere Zunge trägt, wobei für die Bauteile jedes Paares dafür gesorgt wird, daß die Teile einander gegenüberliegen, und durch eine Längsversetzung zwischen letzteren jedes Paar von Zungen mit verschiedenen Längen vom benachbarten Paar durch Querzungen getrennt ist, die die beiden durchgehenden seitlichen Aufbaustreifen verbinden.

Das Herstellungsverfahren, das in dieser Druckschrift beschrieben wird, besteht darin, daß nach dem Anordnen und Festlegen des Halbleiterkristalls auf der Höhe des feien Endes der Zunge mit geringster Länge diagonal der Endabschnitt der Zunge mit größter Länge unter einem derartigen Winkel zurückgelegt wird, daß ihr freies Ende in Kontakt mit dem Kristall kommt, woraufhin der Verbindungsbereich in eine Masse aus einem isolierenden Kunststoffmaterial eingebettet wird.

Dieses bekannte Herstellungsverfahren führt indessen zu Bauelementen, deren äußere Anschlußfahnen nicht zueinander ausgerichtet sind, und deren Gehäuse für eine gegebene Leistung eine erhebliche Größe haben, da in jedem Bauteil zwei Metallzungen Seite an Seite angeordnet sind, was zu einer Zunahme des Platzbedarfes jedes Bauelementes und einer nicht standardisierten Anordnung der Fahnen führt, was eine Nichtbenutzbarkeit bei Standardschaltungen oder in Herstellungsmaschinen derartiger Schaltungen führen kann.

Es ist darüber hinaus schwierig, in einer reproduzierbaren Weise mit hoher Arbeitstaktfolge eine große Genauigkeit bei dem diagonalen Umlegen und optimale Kontaktbedingungen zwischen dem umgelegten Ende und dem Halbleiterkristall zu erzielen, was einen erheblichen Ausschuß im Verlauf der Konformitätsprüfungen zur Folge hat.

Um die genannten Mängel zu beseitigen, ist insbesondere in der Druckschrift EP-A-0 351 749 vorgeschlagen worden, ein vorgestanztes Metallrahmenband zu verwenden, in dem die Zungen ebenfalls in Paaren gruppiert sind, in denen jedes Bauteil ausgehend von einem seitlichen kontinuierlichen Aufbaustreifen in die Richtung des gegenüberliegenden Aufbaustreifens verläuft, der die andere Zunge trägt, wobei abgewinkelte Teile jedem Zungenpaar gegenüber und eine Längsversetzung zwischen letzteren konstruktiv vorgesehen sind.

Die beiden seitlichen Streifen werden durch schrägverlaufende Querzungen verbunden, die die verschiedenen Paare untereinander trennen und die genannten seitlichen Streifen mittels schmalerer Teile verbinden.

Das Herstellungsverfahren besteht insbesondere darin, daß nach der Anordnung und Festlegung eines Halbleiterkristalls an dem freien nach unten umgelegten Ende einer der beiden Zungen gleichzeitig zwei Relativversetzungen der beiden seitlichen Streifen untereinander bewirkt werden, von denen eine (in eine Richtung senkrecht zur Ebene des ausgestanzten Bandes) die die Halbleiterkristalle tragenden Zungen in eine bestimmte parallele Ebene bringt, die unter der Ebene liegt, in der die Zungen sich befinden, die nicht mit Kristallen versehen sind und nach oben umgelegte Enden haben, und von denen die andere (in der Längsrichtung des ausgestanzten Bandes) eine Ausrichtung der beiden Zungen jedes Paares bewirkt.

Die erste Versetzung wird dann umgekehrt, und die beiden Zungen jedes Paares kehren wieder in dieselbe Ebene zurück, wobei der Kristall zwischen den umgelegten einander übergreifenden Enden dieser Zungen eingeklemmt ist.

Anschließend wird das Gehäuse angeformt und werden die üblichen Konformitätsprüfungen durchgeführt.

Dieses Herstellungsverfahren hat dennoch gleichfalls eine gewisse Anzahl von Mängeln.

Die seitlichen Aufbaustreifen müssen jeweils Perforationen für eine schrittweise Mitnahme und somit eine Strecke aus einem dicken Material haben, damit die mechanischen Eigenschaften ausreichen, um die beiden genannten Relativversetzungen zu bewirken, was zu einer Zunahme des nicht benutzten Materials auf der Höhe des anfänglich ausgestanzten Rahmens zur Folge hat.

Bei einer kontinuierlichen Herstellung mittels Bändern großer Länge ergeben sich notwendigerweise Grenzspannungen an dem Teil des ausgestanzten Bandes, der den Relativversetzungen unterworfen wird, was zu Torsionen auf der Höhe des ursprünglichen Bandes, zu Fehlausrichtungen bei der Montage der Zungen jedes Paares und Vorspannungen, beispielsweise in Form von Zugspannungen, an den Verbindungen zwischen den Zungen und dem Kristall am Ende des Bereiches der Relativversetzungen führen kann.

Schließlich können die Verbindungen zwischen den Zungen und dem Kristall eventuell elastischen Federspannungen oder remanenten Verformungskräften ausgesetzt sein, die eine Folge der beiden Relativversetzungen der seitlichen Aufbaustreifen sind, und an diesen Verbindungen brechen, was zumindest bis zum Anformen des Schutzgehäuses auftreten kann.

Ein vorgestanztes Metallrahmenband, das dem aus der oben genannten Druckschrift JP-A-62035549 bekannten Metallrahmenband gleich, ist auch aus US 5 343 072 A bekannt. Bei diesem bekannten Metallrahmenband sind zwei Aufbaustreifen durch Quersegmente verbunden, zwischen denen koplanare Zungenpaare liegen, von denen jede in einem Stück mit einem seitlichen Aufbaustreifen ausgeblidet ist. Die erste Zunge ist mit dem zweiten Aufbaustreifen verbunden. Die zweite Zunge besteht aus einem vorgestanzten Metallstreifen und zwei Metallteilen und ist über zwei Quersegmente mit dem ersten Aufbaustreifen verbunden. Die beiden Zungen eines jeden Paares sind im wesentlichen aufeinander ausgerichtet. Der freie Endabschnitt der ersten Zunge bildet eine Halteaufnahme für den Halbleiterkristall. Der vorgestanzte Metallstreifen am freien Ende der zweiten Zunge kann so umgelegt werden, daß er in Kontakt mit dem Halbleiterkristall kommt.

Schließlich ist aus der Druckschrift EP 0 001 892 A, die sich auf das Fachgebiet der Herstellung von Verbindungen mit elektronischen Bauelementen bezieht, ein Anschlußmetallrahmenband und ein dazu passendes Bauelementgehäuse bekannt. Das Anschlußmetallrahmenband hat zwei Zungen, deren auf einen Halbleiterkristall gerichtete Enden jeweils vorgestanzte Metallstreifen aufweisen, die als umlegbare Verbindungsteile dienen.

Die vorliegende Erfindung hat insbesondere zum Ziel, die genannten Mängel zu beseitigen, genauer gesagt, die Abmessungen des Metallrahmenbandes und den Materialverschnitt beim Ausstanzen dieses Bandes zu verringern und andererseits die Zahl der nach Anformen eines Schutzgehäuses um den Kristall abzutrennenden Metallstreifen zu verringern und darüber hinaus den elektrischen Kontakt mit dem halbleiterkristall sicherer auszubilden.

Ein weiteres Ziel der Erfindung besteht darin, solange wie möglich die feste Anordnung und starre und zuverlässige Selbsthaltung der Bauteile zu sichern, die an dem ausgestanzten Band erhalten werden, insbesondere nach der Unterteilung und Bildung der Zungenteile, die dazu bestimmt sind, die Anschlußfahnen des Bauelementes zu bilden, derart, daß eine Wiederaufwicklung des Haltebandes, das die fertigen und geprüften Bauelemente hält, in Form eines Wickels möglich ist.

Ein zusätzliches Ziel der Erfindung besteht darin, eine genaue Reproduzierbarkeit bei höherer Arbeitstaktfolge der Montagearbeitsvorgänge der leitenden Teile des Bauelementes sicherzustellen, die Verbindungen zwischen den Anschlußzungen und dem Halbleiterkristall zuverlässiger zu machen und ein Verfahren zur kontinuierlichen Herstellung zu liefern, das nur begrenzte Investitionen in den Anlagen und Maschinen notwendig macht und einen verringerten Wartungsaufwand mit sich bringt.

Die oben genannten Ziele werden erfindungsgemäß erreicht durch ein Metallrahmenband, ein Verfahren zum Herstellen von elektronischen Bauelementen und ein elektronisches Bauelement der jeweils eingangs genannten Art in Verbindung mit den Kennzeichnenden Merkmalen des Anspruchs1, den kennzeichnenden Schritten des Anspruchs 6 bzw. den kennzeichnenden Merkmalen des Anspruchs 8.

Die Erfindung wird dank der folgenden Beschreibung weiter verständlich, die sich auf besonders bevorzugte Ausführungsbeispiele bezieht und anhand von nicht beschränkenden Beispielen und unter Bezug auf die zugehörigen schematischen Zeichnungen gegeben wird, in denen
- Fig. 4 eine Draufsicht auf einen Teil eines vorgestanzten Metallrahmenbandes gemäß eines ersten Ausführungs- beispiels der Erfindung zeigt,
- Fig. 5 eine teilweise geschnittene Seitenansicht eines elektronischen Bauelements zeigt, das ausgehend von dem in Fig. 4 dargestellten Band erhalten wird,
- Fig. 6 eine Draufsicht auf einen Teil eines vorgestanzten Metallrahmenbandes gemäß eines zweiten Ausführungsbeispiels der Erfindung zeigt,
- Fig. 7 eine Ansicht im einzelnen in einem anderen Maßstab eines Teils der Zunge und ihrer seitlichen Verlängerung zeigt, die einen Teil des in Fig. 6 dargestellten Teils des Bandes bildet,
- Fig. 8 eine Seitenansicht und eine Schnittansicht längs A-A der in Fig. 7 dargestellten Verlängerung zeigt,
- Fig. 9 eine Draufsicht im anderen Maßstab"des in Fig. 6 dargestellten Teils des vorgestanzten Metallrahmenbandes nach dem Aufbringen eines Bindemittels zum Befestigen eines Halbleiterkristalls zeigt,
- Fig. 10 eine Fig. 9 analoge Ansicht nach der Anordnung des Halbleiterkristalls zeigt,
- Fig. 11 eine Fig. 10 analoge Ansicht nach einem ersten Umlegen der seitlichen Verlängerung in Form eines L unter 90° zeigt, wobei Fig. 11A eine Ansicht in einem anderen Maßstab und eine Vorderansicht der Einzelheit Z in Fig. 11 zeigt,
- Fig. 12 eine zu Fig. 11 analoge Ansicht nach dem vollständigen Umlegen der seitlichen Verlängerung in L-Form zeigt, wobei Fig. 12A eine Ansicht in einem anderen Maßstab und in Perspektive der Einzelheit Y von Fig. 12 zeigt, Fig. 12B eine Seitenansicht der Einzelheit von Fig. 12A zeigt und Fig. 12C eine Draufsicht auf die Einzelheit von Fig. 12A zeigt,
- Fig. 13 eine zu Fig. 12 analoge Ansicht nach dem Aufbringen des leitenden schmelzbaren Kontaktbindemittels in einer Perforation zeigt, die durch den distalen Kontaktteil der Verlängerung geht, der die Anschlußfahne bildet, wobei Fig. 13A eine Ansicht in einem anderen Maßstab von vorne und teilweise geschnitten längs B-B der Einzelheit X in Fig. 13 zeigt,
- Fig. 14 eine zu Fig. 13 analoge Ansicht nach dem Anformen der Schutzgehäuse und von Einschubzapfen zeigt, wobei Fig. 14A eine Vorderansicht des in Fig. 14 dargestellten Teils des vorgestanzten Metallrahmenbandes zeigt,
- Fig. 15 eine zu Fig. 14 analoge Ansicht nach dem beispielsweise durch Herausstoßen erfolgenden Entfernen der. Einschubzapfen zeigt,
- Fig. 16 eine zu Fig. 15 analoge Ansicht nach dem Abtrennen der Zungen und Abschneiden der internen Verbindungsfahnen zeigt,
- Fig. 17 eine zu Fig. 16 analoge Ansicht nach einer ersten Konformitätskontrolle oder einem ersten Konformitätstest und dem Aussondern von fehlerhaften Bauelementen zeigt,
- Fig. 18 eine zu Fig. 17 analoge Ansicht nach der Bildung der externen Verbindungsfahnen ist, wobei die Fig. 18A und 18B verschiedene Arten der Bildung dieser Fahnen zeigen,
- Fig. 19 eine zu Fig. 18 analoge Ansicht nach der Beschriftung der Schutzgehäuse der Bauelemente, insbesondere mit einem Laserstrahl, durch Tampographie oder durch Serigraphie ist,
- Fig. 20 eine zu Fig. 19 analoge Ansicht nach einer zweiten Konformitätskontrolle oder einem zweiten Konformitätstest, insbesondere unter Wärme und nach dem Aussondern der fehlerhaften Bauelemente ist,
- Fig. 21 eine perspektivische Ansicht eines elektronischen Bauelements zeigt, das nach einem zweiten Ausführungsbeispiel der Erfindung erhalten wird, wobei die inneren Elemente, die im Schutzgehäuse angeordnet sind, transparent dargestellt sind, und
- die Fig. 22A und 22B Seitenansichten in einem anderen Maßstab und im Schnitt jeweils längs einer Mittellängsebene und einer Querebene, die in Fig. 22A mit C-C angegeben ist, des in Fig. 21 dargestellten elektronischen Bauelements zeigen.

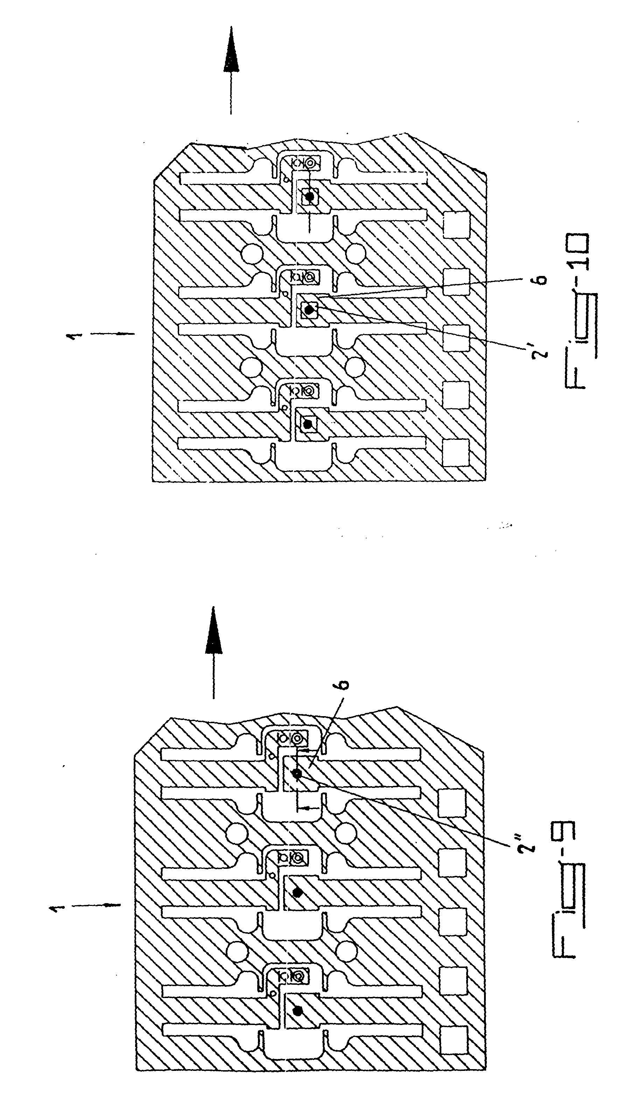

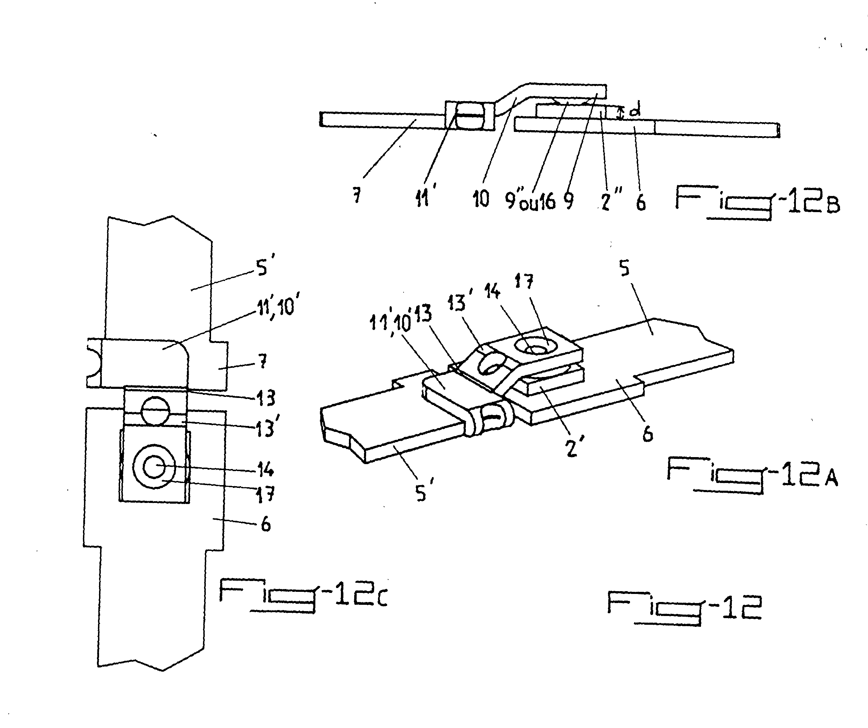

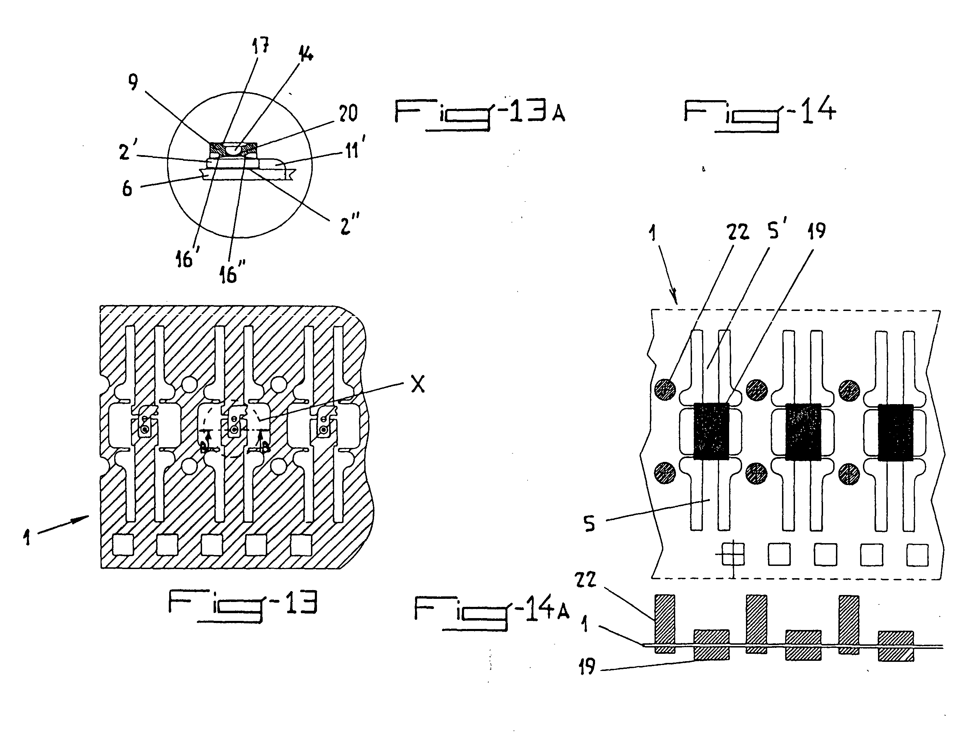

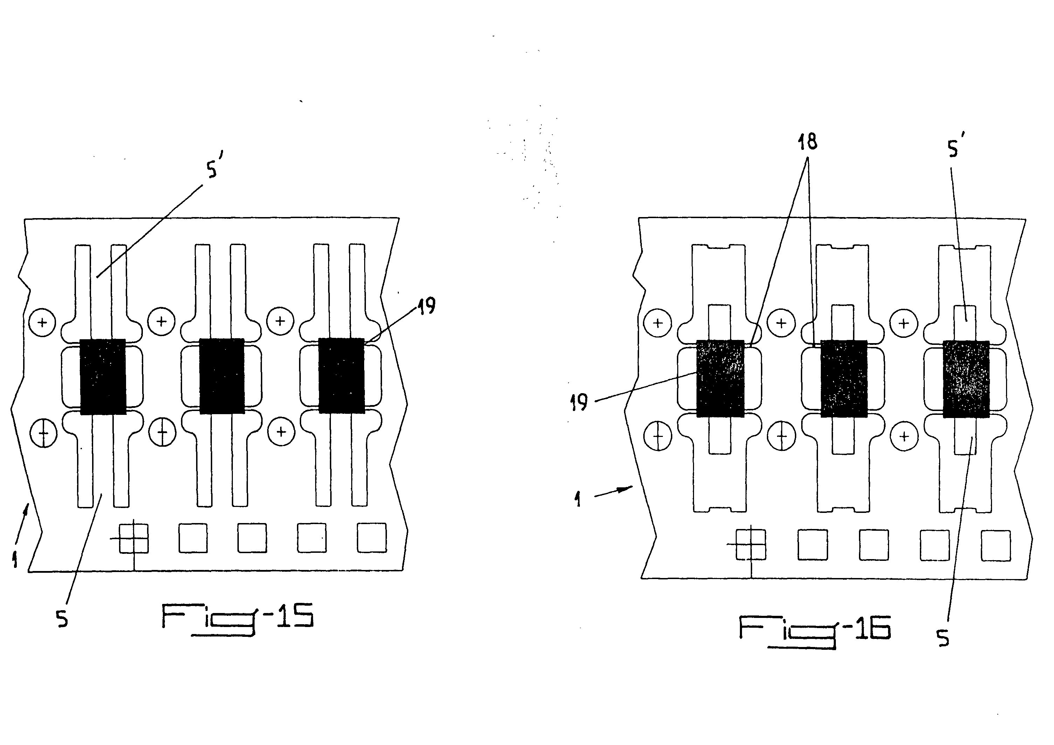

Wie es in den Fig. 4 bis 12 der zugehörigen Zeichnungen dargestellt ist, besteht das vorgestanzte metallische Rahmenband 1 zur Herstellung von elektronischen Bauelementen 2 mit Halbleiterkristallen 2' im Grunde aus wenigstens zwei seitlichen in Richtung Seiner Längsachse verlaufenden Aufbaustreifen 3 und 3', die miteinander in regelmäßigen Intervallen über Quersegmente 4 verbunden sind, zwischen denen koplanare Zungenpaare 5, 5' ausgebildet sind, von denen jede Zunge in einem Stück mit einem der seitlichen Aufbaustreifen 3 oder 3' ausgebildet ist, und sich in Richtung ihrer längsachse zu dem anderen seitlichen Aufbaustreifen 3' oder 3 erstreckt, ohne die andere Zunge des besagten Paares zu berühren.

Gemäß der Erfindung sind die Zungen 5 und 5' jedes Paares genau zueinander ausgerichtet, weist eine der Zungen 5 jedes Paares einen freien Endabschnitt 6 auf, der eine Halteaufnahme für den Halbleiterkristall 2' bildet, und weist die andere Zunge 5' jedes Paares auf der Höhe ihres freien Endes 7 einen Verbindungsteil 8 in Form eines vorgestanzten Metallstreifens auf, der so umgelegt werden kann, daß er mit dem Halbleiterkristall 2' in Berührung kommt, so daß er sich im wesentlichen in dem Volumen befindet, das von zwei zur Ebene des Metallrahmen bandes rechtwinkeligen Ebenen bestimmt wird, die durch die parallel zudenlängsachsen der Zungen verlaufenden Längsränder der Zungen (5,5') gehen.

In dieser Weise sind alle elektrischen Anschlußelemente des fertigen elektronischen Bauelements 2 in einem einzigen vorgestanzten Metallrahmenband 1 integriert, was aus diesem Grunde eine genaue Montage begünstigt und eine fortlaufende Produktion ermöglicht, wobei nur zwei elektrische Verbindungspunkte in dem besagten Bauelement 2 vorgesehen sind.

Die Zungen 5, 5' sind weiterhin zueinander ausgerichtet, und es ist kein seitlich vorstehender Teil nach dem Umlegen des Verbindungsteils 8 in Form eines Metallstreifens vorhanden, so daß das Schutzgehäuse 19 einen geringeren Platzbedarf, insbesondere was die Breite anbetrifft, hat.

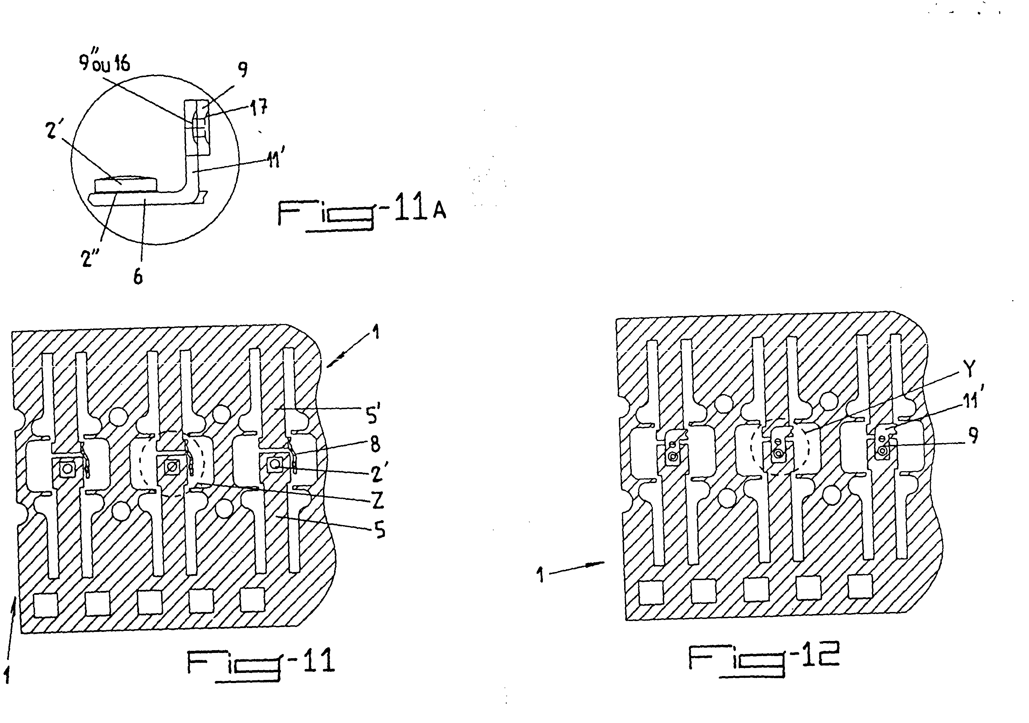

Bei einem ersten speziellen Ausführungsbeispiel der Erfindung, das in den Fig. 4 und 5 der zugehörigen Zeichnungen dargestellt ist, ist der Verbindungsteil 8 in Form eines Metallstreifens, der eine langgesteckte geradlinige Form hat, im freien Endabschnitt 7 der entsprechenden Zunge 5' ausgestanzt, wobei er mit letzterer an seinem zur anderen Zunge 5 gerichteten Ende fest verbunden ist, und die Länge des besagten Teils 8 in Form eines Metallstreifens so gewählt ist, daß nach zwei Umbiegungen um 90° des letzteren, und zwar einer auf der Höhe des Endes, das fest mit der Zunge 5' verbunden ist, der distale freie Teil 9 des Endsegmentes 10 in Kontakt mit dem Halbleiterkristall 2' kommt, der am freien Endabschnitt 6 der anderen Zunge 5 befestigt ist.

Vorzugsweise sind die beiden Bereiche 21 und 21', an denen der Verbindungsteil 3 in Form eines Metallstreifens um 90° gebogen wird, um eine Strecke beabstandet, die der Höhe des Halbleiterkristalls 2' gegebenenfalls zuzüglich der Höhe eines vorstehenden gewölbten Teils 9'' ist, der an der Fläche 9' des freien distalen Teils 9 ausgebildet ist und mit dem Kristall 2'' in Kontakt kommt.

Aufgrund dieser Anordnung wird der Kristall 2' mechanisch durch den freien distalen Teil 9, insbesondere während der Phase der Verfestigung des Bindemittels 2'', gehalten, das den Kristall 2' an der Halteaufnhame 6 der entsprechenden Zunge 5 festlegt.

Bei einem zweiten bevorzugten Ausführungsbeispiel der Erfindung, das in den Fig. 6 bis 13 der zugehörigen Zeichnungen dargestellt ist, besteht der Verbindungsteil in Form eines Metallstreifens aus einer vorgeformten seitlichen Verlängerung, die im wesentlichen L-förmig ist und aus einem äußeren Segment im wesentlichen parallel zu den Längsachsen der betreffenden Zungen 5, 5' und einem mittleren Verbindungssegment 11 gebildet ist, das im wesentlichen senkrecht zu diesen Längsachsen der betreffenden Zungen 5, 5' verläuft, und vorzugsweise mit einer Biegeschwächungszone 12 versehen ist, wobei die Verlängerung 8 eine Anschlußfahne zum Halbleiterkristall 2' bildet, der am freien Endabschnitt 6 der anderen Zunge 5 angeordnet ist, nachdem sie auf der Höhe dieser Schwächungszone 12 umgelegt worden ist.

Diese Schwächungszone 12 kann durch Stanzen von zwei seitlichen Einschnitten oder durch eine kreisförmige oder langgestreckte Öffnung im mittleren Verbindungssegment 11 vorzugsweise in der Nähe des freien Endabschnittes 6 der entsprechenden Zunge 5' erhalten werden.

Es sei darauf hingewiesen, daß die beiden oben beschriebenen Ausführungsvarianten des Verbindungsteils 8 in Form eines Metallstreifens es erlauben, ein vorgestanztes Metallrahmenband 1 gemäß der Erfindung zur Bildung von elektronischen Bauelementen nach bekannten, im vorhergehenden erwähnten technischen Verfahren, nämlich dem Verfahren mit einem Edelmetallverbindungsdraht und dem Verfahren mit einem eingesetzten Metallteil zu verwenden, indem entweder der Verbindungsteil 8 in Form eines Metallstreifens beim ersten Ausführungsbeispiel nicht umgelegt wird oder die die seitliche Verlängerung 8 beim zweiten Ausführungsbeispiel vorzugsweise auf der Höhe der Schwächungszone 12 abgeschnitten wird.

Gemäß eines Merkmals der Erfindung, das insbesondere in den Fig. 7, 8, 12A, 12B und 12C der zugehörigen Zeichnungen dargestellt ist, zeigt das Endsegment 10 der Verlängerung 8 zwei Knicke oder Falten 13 und 13' im Abstand voneinander und mit entgegengesetzten Ausrichtungen, die so ausgebildet sind, daß der freie distale Abschnitt 9 des Endsegmentes 10, der dazu bestimmt ist, mit dem Halbleiterkristall 2', gegebenenfalls über einen gewölbten vorstehenden Teil 9'', der durchbohrt ist oder nicht, und an der Fläche 9' des Teils 9 auf den Kristall 2' zugerichtet ausgebildet ist, in Kontakt zu kommen, in einer Ebene angeordnet ist, die parallel bezüglich der Ebene versetzt ist, in der der Teil 10' des Endsegmentes 10 liegt, der nahe am Verbindungszwischensegment 11' und den beiden Falten 13 und 13' gegenüberliegt.

Die Ausbildung eines gewölbten vorstehenden Teils 9'' oder einer anderen vorstehenden Struktur, die durch Verformung des entsprechenden Bereiches des freien distalen Abschnittes 9 angebracht oder ausgebildet ist, "erlaubt es, genau den Kontaktbereich oder Kontaktpunkt mit der Oberfläche des Kristalls 2' zu bestimmen, was im wesentlichen Fehlkontakte, insbesondere bei Kristallen 2' mit planarer Struktur ausschließt, bei denen der Kontaktbereich verringert ist.

Der gewölbte vorstehende Teil 9'' kann mit einem oder mehreren Bohrungen zum Durchgang des schmelzbaren leitenden Kontaktbindemittels 20 versehen sein.

Bei einer bevorzugten Ausbildungsvariante der Erfindung ist der freie distale Teil 9 des Endsegmentes 10 mit einer Perforation 14 versehen, die bezüglich des Kontaktbereiches 15 des Teils 9 quer zu dessen Ebeneverläuft und zu dem Halbleiterkristall 2' nach dem Umlegen des Verbindungsteils 8 in Form eines Metallstreifens zentriert ist.

In vorteilhafter Weise mündet diese querverlaufende Perforation 14 an der Fläche 9' des freien distalen Teils 9, die zum Halbleiterkristall 2' nach dem Umlegen gerichtet ist, und zwar auf der Höhe einer vorstehenden Struktur 16 in Form eines Kraters, dessen Ringwand 16' als ander zungeangeformte versfärkung 17, die die Offnung der besagten Perforation 14 begrenzt, bezüglich der Oberfläche der besagten Fläche 9' des distalen Teils 9 vorsteht, die nach dem Umlegen zum Halbleiterkristall 2' gerichtet ist.

Um das Aufbringen des schmelzbaren leitenden Bindemittels 20 zu erleichtern und eine unerwünschte Ablagerung des schmelzbaren leitenden Bindemittels 20 jenseits des Kontaktbereiches 15 zu vermeiden, kann die Perforation 14 auf der Höhe der Fläche des freien distalen Teils 9, die der Fläche 9' gegenüberliegt, die dazu bestimmt ist, zum Halbleiterkristall 2' gewandt zu werden, auf dem Boden einer Verstärkung 17, beispielsweise einer kreisförmigen Schale, münden.

Die genannten Ausbildungen erlauben es somit, das Aufbringen des Bindemittels 20 zu erleichtern, einen gegebenenfalls vorhandenen Überschuß an Bindemittel 20 über die Kapillarität zu absorbieren und in der Verstärkung 17 zurückzuhalten und eine Kontaktzone 15 zu garantieren, die genau, klar begrenzt und mit Genauigkeit identisch reproduzierbar ist.

Die vorstehende Struktur 16 in Form eines Kraters und die Verstärkung 17 werden durch Verformen des Ringbereiches gebildet, der die Perforation 14 außen umschließt.

Um ein leichtes Umlegen (beispielsweise durch einfache mechanische Arbeitsvorgänge) und eine genaue Ausrichtung des Endsegmentes 10 der Verlängerung 8 nach dem Umlegen zu garantieren, bildet die Schwächungszone 12 zum Umlegen, die vorzugsweise im mittleren Verbindungssegment 11 ausgebildet ist, eine Faltlinie 12', vorzugsweise parallel zu den Achsen der entsprechenden Zonen 5, 5', und erlaubt es diese Schwächungszone, die Verlängerung 8 um 180° bis zu einem Flächenkontakt zwischen dem umlegbaren Teil 11' des mittleren Verbindungssegmentes 11 und dem freien Ende 7 der entsprechenden Zunge 5' umzulegen.

Gemäß eines Merkmals der Erfindung, das in den Fig. 6 bis 8 und 12B der zugehörigen Zeichnung dargestelt ist, ist der Abstand d zwischen dem oberen Rand 16'' der Ringwand 16' der vorstehenden Struktur 16 in Form eines Kraters und der Fläche des umlegbaren Teils 11' des mittleren Verbindungssegmentes 11, der mit dem freien Ende 7 der entsprechenden Zunge 5' in Kontakt kommt, nach dem vollständigen Umlegen der seitlichen Verlängerung 8 im wesentlichen mit der Höhe des Halbleiterkristalls 2' identisch.

Die Bestimmung des genannten Abstandes d durch Vorformen der Verlängerung 8 und die genaue Begrenzung des Umlegens der besagten Verlängerung 8 durch oberflächenförmigen Anschlag erlaubt es in reproduzierbarer, leichter und genauer Weise, ein Halten des Kristalls 2' durch Einklemmen zwischen dem freien distalen Teil der Zunge 5' oder ihrem vorstehenden Teil oder ihrer vorstehenden Struktur 9'' oder 16 und der Halteaufnahme 6 der Zunge 5 zu erreichen, was eine mechanische Unbeweglichkeit des Kristalls, insbesondere vor der Verfestigung des leitenden Bindemittels der Befestigung und des Kontaktes 20 und vor dem Anformen des Schutzgehäuses 19 garantiert.

Gemäß eines weiteren Merkmals der Erfindung, wie es insbesondere in den Fig. 6 und 14 bis 20 der zugehörigen Zeichnung dargestellt ist, haben die querverlaufenden Segmente 4 Verlängerungen 18 in Form von Fahnen, deren freie Endabschnitte 18' in das Volumen vorstehen, das die Verbindung zwischen den Zungen 5, 5' und dem Kristall 2' umgibt und schließlich von der Masse des Schutzgehäuses 19 eingenommen wird, das durch Anformen ausgebildet wird, was es somit erlaubt, die elektronischen Bauelemente 2 am Metallrahmenband 1 nach dem Abschneiden der Zungen 5 und 5' zu halten und festzulegen.

Vorzugsweise weist jedes querverlaufende Segment 4 zwei Verlängerungen 18 in Form von beabstandeten Fahnen an jeder seiner Seiten auf.

Um das Material, das das vorgestanzte Metallrahmenband 1 bildet, am besten auszunutzen und zu einer höheren Dichte der Zungen 5, 5' und somit der Bauelemente 2 pro Längeneinheit zu gelangen, haben die querverlaufenden Segmente 4 jeweils einen Abschnitt 4' geringerer Breite den freien Enden der Zungen 5, 5' gegenüber, so daß der in dieser Weise freigelegte Bereich des Metallrahmenbandes wenigstens teilweise dazu benutzt wird, die umlegbare seitliche Verlängerung 8 zur Bildung der Anschlußfahne abzuschneiden.

Die vorliegende Erfindung hat gleichfalls ein Verfahren zum Herstellen von elektronischen Bauelementen mit Halbleiterkristallen ausgehend von einem vorgestanzten Metallrahmenband zum Ziel, das wenigstens aus zwei seitlichen längsverlaufenden Aufbaustreifen 3 und 3' besteht, die miteinander in regelmäßigen Intervallen durch querverlaufende Segmente 4 verbunden sind, zwischen denen koplanare Paare von Zungen 5 und 5' vorgesehen sind, die jeweils in einem Stück mit einem der seitlichen Aufbaustreifen ausgebildet sind und in eine Richtung zum anderen besagten seitlichen Aufbaustreifen verlaufen, ohne die andere Zunge des betreffenden Paares zu berühren.

Wie es in den Fig. 4, 5, 6 und 9 bis 20 der zugehörigen Zeichnungen dargestellt ist, besteht dieses Verfahren im wesentlichen darin, daß ein vorgestanztes Metallrahmenband 1 mit einer ein Aufwickeln in Rollen ermöglichenden Länge, wie es oben beschrieben wurde, zugeführt wird und dafür gesorgt wird, daß es in Längsrichtung schrittweise verschoben wird, währenddessen die folgenden Arbeitsvorgänge nacheinander auf der Höhe jedes Zungenpaars 5, 5' ausgeführt werden:
- Anordnen eines Halbleiterkristalls 2' an einer Halteaufnahme 6, die so ausgebildet ist, daß sie sich auf der Höhe des freien Endabschnittes der ersten Zunge 5 befindet,
- Umlegen eines Verbindungsteils 8 in Form eines vorgestanzten Metallstreifens, der fest mit dem freien Ende 7 der zweiten Zunge 5' verbunden ist, und Verbindung mit dem Halbleiterkristall 2',
- Anformen eines Schutzgehäuses 19 um den Verbindungsbereich zwischen den Zungen 5, 5' und dem Kristall 2',
- Abtrennen der beiden Zungen 5 und 5' und Abschneiden und Formen von äußeren Anschlußfahnen,
- Messen und Prüfender Bauelemente 2 und Aussondern von fehlerhaften Bauelemente 2.

Gemäß einer ersten Ausbildungsvariante der Erfindung, die in den Fig. 6 und 9 bis 12 der zugehörigen Zeichnungen dargestellt ist, besteht der Teil 8 in Form eines Metallstreifens der zweiten Zunge 5' vor dem Umlegen aus einer seitlichen Verlängerung in L-Form, die über das Endsegment 11, das die Basis des L bildet, mit der besagten zweiten Zunge 5' verbunden ist, und deren Segment 10, das den anderen Schenkel des L bildet, parallel zu den besagten Zungen 5, 5' verläuft, wobei ein freier distaler Teil 9 der Halteaufnahme 6 der ersten Zunge 5 zugewandt, jedoch in einer Ebene angeordnet ist, die parallel bezüglich der Ebene versetzt ist, in denen die Zungen 5 und 5' liegen, erfolgt das Umlegen der genannten Verlängerung 8 einerseits auf der Höhe einer Schwächungszone 12 des Segmentes 11, das die Basis des L bildet, und längs einer Fallinie 12' parallel zu den Längsachsen der Zungen 5, 5', bis der umlegbare Teil 11' des besagten Segmentes, das die Basis des L bildet, mit dem freien Ende 7 der zweiten Zunge 5' in Kontakt kommt.

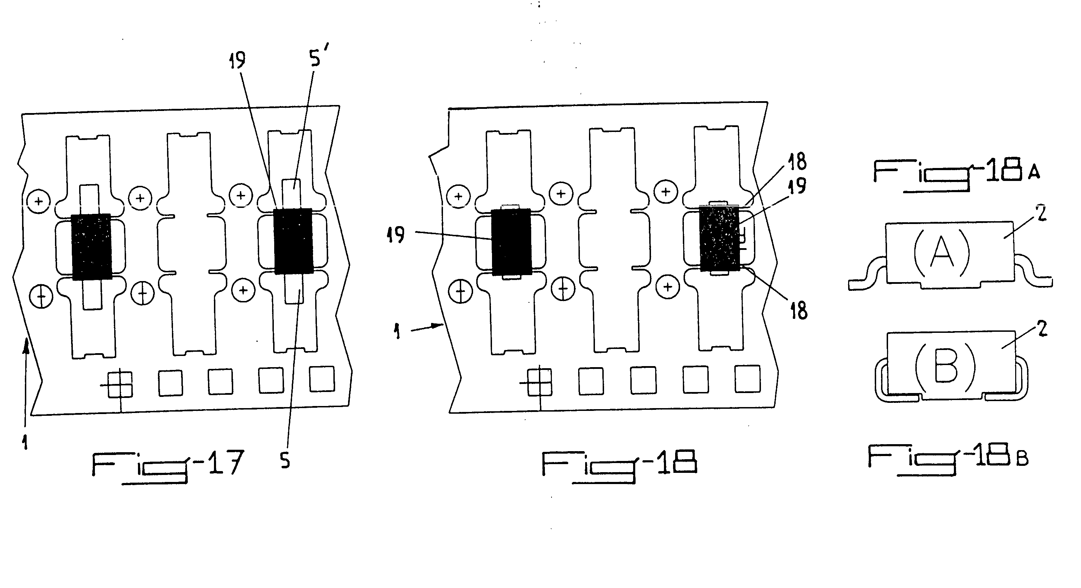

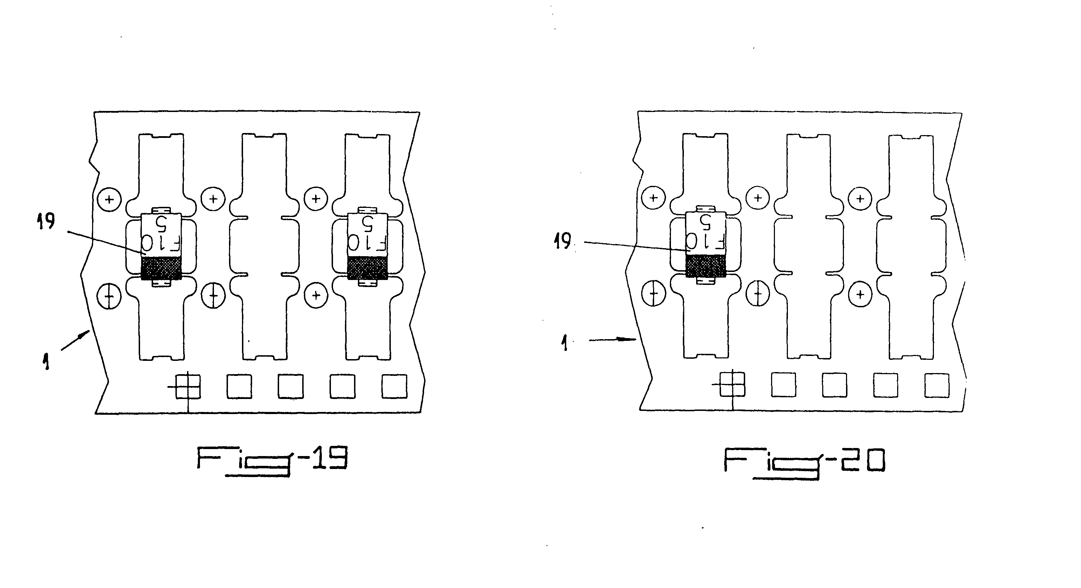

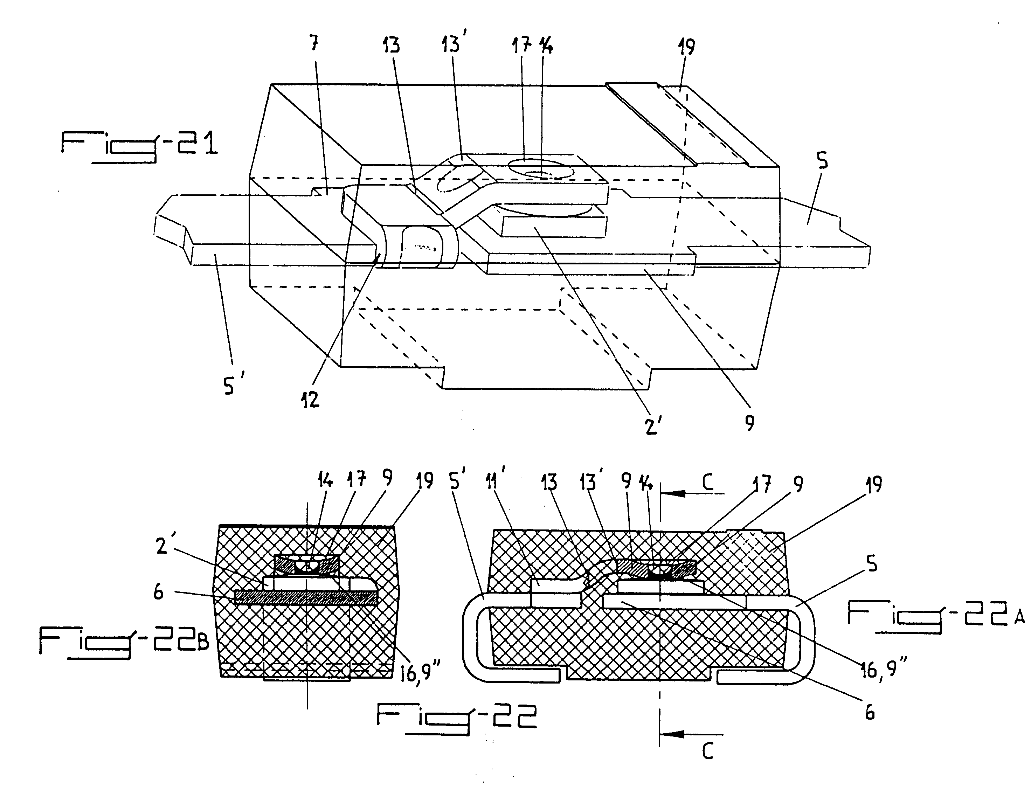

Das Umlegen der Verlängerung 8 in L-Form erfolgt über eine erste Faltbewegung um 90° auf der Höhe der Schwächungszone 12, auf die eine zweite Faltbewegung um 90° auf der Höhe dieser Zone folgt, wodurch der umlegbare Teil 11' des Segmentes 11, der die Basis des L bildet, vollständig gegen die Oberfläche des freien Endes 7 der zweiten Zunge 5' umgelegt wird, wobei die zweite Faltbewegung gegebenenfalls in wenigstens zwei Teilfaltbewegungen aufgeteilt sein kann (Fig. 11 und 12).

Gemäß einer zweiten Ausbildungsvariante der Erfindung, die in den Fig. 4 und 5 der zugehörigen Zeichnung dargestellt ist, wird der Verbindungsteil 8 in Form eines Metallstreifens, der in den freien Endabschnitt 7 der zweiten Zunge 5' gestanzt ist und eine geradlinige langgestreckte Form hat, einmal um 90° auf der Höhe seines Endes umgelegt, das mit der zweiten Zunge 5' fest verbunden ist, und ein zweites mal um 90° in Richtung der ersten Zunge 5 umgelegt, wobei die beiden Faltbereiche um eine Strecke beabstandet. sind, die der Höhe des Halbleiterkristalls 2' entspricht, und die Länge des besagten Teils 8 in Form eines Metallstreifens derart ist, daß der freie distale Teil 9 nach dem Umlegen in einen Kontakt mit dem Halbleiterkristall 2' kommt.

Wie es in den Fig. 5, 13, 22A und 22B der zugehörigen Zeichnungen dargestellt ist, wird die Verbindung des Halbleiterkristalls 2' mit der zweiten Zunge 5' nach dem Umlegen des Teiles 8 in Form eines Metallstreifens über einen mechanischen Kontakt mit vorstehenden Teil 9'' oder 16 am freien distalen Teil 9 und durch Anordnen eines leitenden schmelzbaren Bindemittels zwischen letzterem und dem Kristall 2' oder durch Injizieren eines leitenden schmelzbaren Bindemittels 20 in eine querverlaufende Perforation 14 verwirklicht, die im freien distalen Teil 9 vorgesehen ist und an der Fläche 9' des letzteren, die zu dem besagten Kristall 2' gerichtet ist, auf einer Höhe einer gewölbten Struktur oder eines gewölbten vorstehenden Teils 9'' oder eines Teils in Form eines Kraters 16 mündet, was zu einem mechanischen Kontakt mit dem besagten Kristall 2' nach dem Umlegen des Verbindungsteils 8 in Form eines Metallstreifens führt.

Gemäß eines Merkmals der Erfindung wird die Masse, die das Schutzgehäuse 19 bildet, gleichfalls um die freien Enden 18' der Verlängerungen 18 in Form von Fahnen gegossen, die von den querverlaufenden Segmenten 4 der zungen 5,5' ausgehen und damit fest verbunden sind, wobei fehlerhafte Bauelemente 2 dadurch ausgesondert werden, daß auf letzteren ein ausreichender Druck zum Brechen der Verbindung zwischen dem Gehäuse 19 und den Verlängerungen 18 in Form von Fahnen ausgeubt wird.

Dank dieser Ausbildung kann das vorgestanzte Metallrahmenband 1 von einem Wickel abgewickelt werden und kann nach der Bildung und Beschriftung der elektronischen Bauelemente 2 und nach einer Kontrolle und der Aussonderung der fehlerhaften Bauelemente 2 das Metallrahmenband 1, das die fertigen Bauelemente 2 sicher durch die Verlängerungen 8 gehalten trägt, wieder in Form eines Wickels aufgewickelt werden.

Im übrigen können die Kontrollen oder Prüfungen der elektrischen Eigenschaften an den total isolierten Bauelementen 2 (Anschlußfahnen in Luft) ausgeführt werden, und können die beiden äußeren Anschlußfahnen gebildet werden, während die Bauelemente 2 noch am vorgestanzten Metallrahmenband 1 gehalten sind, was sicherstellt, daß sie regelmäßig, fortlaufend und in einer großen Zahl befördert werden und daß sie ihre Ausrichtung im Verlauf aller Herstellungsarbeitsvorgänge der besagten Bauelemente 2 beibehalten.

Da darüber hinaus das vorgestanzte Metallrahmenband 1 als Halterung während aller Herstellungsarbeitsvorgänge dient, sind die Beförderungen an den Ausrüstungsteilen stark vereinfacht, ja sogar beseitigt.

Das Herstellungsverfahren gemäß der Erfindung kann insbesondere aus den folgenden Schritten bestehen:
- Abrollen und Befördern durch schrittweises Mitnehmen eines vorgestanzten Metallrahmenbandes 1, wie es im vorhergehenden beschrieben wurde, das insbesondere Zungenpaare 5 und 5' umfaßt, deren Zungen 5' mit seitlichen Verlängerungen 8 versehen sind, die vorgeformt und mit Schwächungszonen 12 des bevorzugten Umlegens versehen sind (Fig. 6),
- Aufbringen einer bestimmten Menge eines leitenden Bindemittels 2' auf einen freien Endabschnitt 6 der Zungen 5 (Fig. 9),
- Aufsetzen eines vororientierten Halbleiterkristalls 2' (der beispielsweise mit einer Sperre oder einer gewölbten Fläche auf der Höhe einer seiner Funktionsflächen versehen ist) auf dem leitenden Bindemittel 2' (Fig. 10),
- Umlegen um 90° der seitlichen Verlängerung 8 auf der Höhe der Schwächungszone 12 (Fig. 11),
- Umlegen um 180° der seitlichen Verlängerung 8, was dadurch begrenzt ist, daß der umlegbare Teil 11' des Zwischenverbindungssegmentes 11 mit dem freien Ende 7 der Zunge 5' in Oberflächenanlage kommt (Fig. 12),
- Anordnen des schmelzbaren leitenden Bindemittels 20 auf der Höhe des Kontaktbereiches zwischen der Verlängerung 8 und dem Kristall 2' beispielsweise durch Einbringen in eine querverlaufende Perforation 14, die auf der Höhe einer vorstehenden Struktur oder eines vorstehenden Teils 9'' oder 16 des freien distalen Teils 9 der Verlängerung 8 mündet (Fig. 13 und 13A),
- Verfestigen des Bindemittels 20,
- Anformen eines Schutzgehäuses 19 um den Halbleiteranschluß und die Enden 18' der Verlängerungen 18, die von den querverlaufenden Segmenten 4 ausgehen, und Anformen der Einschubzapfen 22 (Fig. 14 und 14A),
- Verzinnen der Teile der Zungen 5 und 5', die nicht im Schutzgehäuse 19 eingeschlossen sind,
- Beseitigen durch Herausstoßen der Einschubzapfen 22 (Fig. 15),
- Abschneiden der Anschlußfahnen anschließend an ein Abtrennen der Zungen 5 und 5' (Fig. 16),
- elektrische Meßprüfungen und Aussondern von außerhalb der Normen liegenden Bauelemente,
- Formen der Anschlußfahnen (Fig. 18),
- Beschriften der verbleibenden Bauelemente 2, was die Kennzeichnung des Bauelementes und seine Polarität anbetrifft (Fig. 19),
- Wärmebeständigkeitsprüfungen und Aussondern von Bauelementen 2 außerhalb der Normen (Fig. 20) und
- Verpackung des Rahmenbandes 1 mit den festsitzenden Bauelementen nach dem Aufrollen und anschließendes Aufbewahren oder Verschicken.

Unter den Vorteilen des beschriebenen Verfahrens, die im Grunde aus den Besonderheiten des vorgestanzten Metallrahmenbandes resultieren, das oben beschrieben wurde, kann man insbesondere die Möglichkeit hervorheben, daß ein derartiges vorgestanztes Metallrahmenband 1 für die Herstellung von Bauelementen nach traditionellen technischen Verfahren verwandt werden kann (indem die seitliche Verlängerung 8 auf der Höhe ihrer Faltlinie abgeschnitten wird), daß lose Kristalle 2' oder Kristalle 2' aus einer dünnen Schicht verwandt werden können, daß die Notwendigkeit fehlt, vor dem Anformen des Gehäuses die Anschlüsse vorab zu schützen, daß das Produkt (die Bauelemente) in einem fortlaufenden Band und mit großer Flexibilität gefertigt werden kann, daß die Bauelemente und das Anfangsband in Form eines Wickels leicht gelagert und gehandhabt werden können, daß es möglich ist, wirtschaftlich Montage-, Transport- und Sortieranlagen mit hoher Arbeitstaktfrequenz zu verwenden, indem man auf traditionelle Techniken zurückgreift, deren Handhabung über klassische Produktionstechniker sichergestellt werden kann.

Die vorliegende Erfindung hat gleichfalls eine elektronisches Bauelement mit Halbleiterkristall zum Ziel, das mittels eines Herstellungsverfahrens erhalten wird, wie es oben beschrieben wurde, und insbesondere von einem vorgestanzten Metallrahmenband dergenannten Art ausgeht, welches Bauelement im wesentlichen aus einem Schutzgehäuse 19 besteht, das den Halbleiterverbindungsbereich und zwei Metallzungen 5, 5' umgibt, die die äußeren Verbindungszungen bilden, von denen eine den Halbleiterkristall 2' auf der Höhe seines Endes trägt, das sich im Gehäuse 19 befindet, dadurch gekennzeichnet, daß die zweite Zunge 5' auf der Höhe ihres Endes, das sich im Schutzgehäuse 19 befindet, eine vorgeformte Verlängerung 8 aufweist, die in einem Stück mit dieser Zunge 5' ausgebildet ist und durch seitliches Umlegen so umgelegt ist, daß sie in Kontakt mit dem Halbleiterkristall 2' gekommen ist.

In vorteilhafter Weise hat die vorgeformte Verlängerung 8 eine L-Form mit einem mittleren Verbindungssegment 11, das auf sich selbst umgelegt wird, und einem zweifach umgelegten äußeren Segment, dessen äußerer distaler Teil 9 in Kontakt mit der oberen Außenfläche des Halbleiterkristalls 2' gegebenenfalls in Form einer Wölbung über einen dazwischen angeordneten vorstehenden Teil oder eine Wölbung 9'' oder eine vorstehende Struktur 16 in Form eines Kraters steht, der die Öffnung einer querverlaufenden Perforation 14 bildet, die ein leitendes Kontaktbindemittel 20 enthalt, wodurch der elektrische Anschluß und wenigstens teilweise die mechanische Halterung des besagten distalen Endabschnittes am Halbleiterkristall 2' sichergestellt ist.

Schließlich hat die Erfindung unter anderem auch ein elektronisches Bauelement 1 mit einem Halbleiterkristall zum Ziel, das mittels des Herstellungsverfahrens, das oben als Variante beschrieben wurde, erhalten wird und insbesondere von einem vorgestanzten Metallrahmenband 1, wie es im vorhergehenden beschrieben wurde, ausgeht, welches ein Schutzgehäuse 19 umfaßt, das den Verbindungsbereich und die beiden Metallzungen 5 und 5', die die äußeren Anschlußfahnen bilden, umgeben, von denen eine den Halbleiterkristall 2' auf der Höhe ihres im Gehäuse 19 befindlichen Endes trägt, dadurch gekennzeichnet, daß die zweite Zunge 5' auf der Höhe ihres Endes im Gehäuse 19 einen Teil 8 in Form eines Metallstreifens aufweist, der langgestreckt geformt und in der Zunge 5' ausgestanzt ist und durch zwei getrennte Faltungen um 90° zu einer Anschlußfahne in Kontakt mit dem Halbleiterkristall 2' auf der Höhe seines distalen Endabschnittes 9 gebildet ist (Fig. 4 und 5).

Wie es in Fig. 5 dargestellt ist, ist der Abstand d zwischen den beiden Faltbereichen um 90° 21 und 21' im wesentlichen gleich der Höhe des Halbleiterkristalls 2', so daß der distale Endabschnitt 9 in Kontakt mit der oberen Außenfläche des Halbleiterkristalls 2' über einen gewölbten vorstehenden Teil einer vorstehenden Struktur 16 in Form eines Kraters steht, der die Öffnung einer querverlaufenden Perforation 14 bildet, die ein leitendes Kontaktbindemittel 20 aufnimmt, das die elektrische Verbindung und wenigstens teilweise die mechanische Halterung des besagten distalen Endabschnittes 9 am Halbleiterkristall 2' sicherstellt.

Es versteht sich, daß die Erfindung nicht auf die beschriebenen und in den zugehörigen Zeichnungen dargestellten Ausführungsbeispiele beschränkt ist. Es bleiben Abwandlungen möglich, insbesondere in Hinblick auf den Aufbau der verschiedenen Bauteile oder bezüglich des Ersatzes durch äquivalente Techniken, ohne den Schutzbereich der Erfindung zu verlassen.

### Einfügung 1:

ein vorgestanztes Metallrahmenband, ein Verfahren zum Herstellen von elektronischen Bauelementen mit Halbleiterkristallen und ein elektronisches Bauelement mit Halbleiterkristall gemäß den Oberbegriffen der Patentansprüche 1, 6 bzw. 8.

### Einfügung 2:

### (die zur Bildung der Oberbegriffe der Patentansprüche 1, 6 und 8 herangezogen worden ist)

### Einfügung 3:

Ein vorgestanztes Metallrahmenband, das dem aus der oben genannten Druckschrift JP-A-62035549 bekannten Metallrahmenband gleicht, ist auch aus US 5 343 072 A bekannt. Bei diesem bekannten Metallrahmenband sind zwei Aufbaustreifen durch Quersegmente verbunden, zwischen denen koplanare Zungenpaare liegen, von denen jede in einem Stück mit einem seitlichen Aufbaustreifen ausgebildet ist. Die erste Zunge ist mit dem zweiten Aufbaustreifen verbunden. Die zweite Zunge besteht aus einem vorgestanzten Metallstreifen und zwei Metallteilen und ist über zwei Quersegmente mit dem ersten Aufbaustreifen verbunden. Die beiden Zungen eines jeden Paares sind im wesentlichen aufeinander ausgerichtet. Der freie Endabschnitt der ersten Zunge bildet eine Halteaufnahme für den Halbleiterkristall. Der vorgestanzte Metallstreifen am freien Ende der zweiten Zunge kann so umgelegt werden, daß er in Kontakt mit dem Halbleiterkristall kommt.

Schließlich ist aus der Druckschrift EP 0 001 892 A, die sich auf das Fachgebiet der Herstellung von Verbindungen mit elektronischen Bauelementen bezieht, ein Anschlußmetallrahmenband und ein dazu passendes Bauelementgehäuse bekannt. Das Anschlußmetallrahmenband hat zwei Zungen, deren auf einen Halbleiterkristall gerichtete Enden jeweils vorgestanzte Metallstreifen aufweisen, die als umlegbare Verbindungsteile dienen.

### Einfügung 4:

genauer gesagt, die Abmessungen des Metallrahmenbandes und den Materialverschnitt beim Ausstanzen dieses Bandes zu verringern und andererseits die Zahl der nach Anformen eines Schutzgehäuses um den Kristall abzutrennenden Metallstreifen zu verringern und darüber hinaus den elektrischen Kontakt mit dem Halbleiterkristall sicherer auszubilden.

### Einfügung 5:

Die oben genannten Ziele werden erfindungsgemäß erreicht durch ein Metallrahmenband, ein Verfahren zum Herstellen von elektronischen Bauelementen und ein elektronisches Bauelement der jeweils eingangs genannten Art in Verbindung mit den kennzeichnenden Merkmalen des Anspruchs 1, den kennzeichnenden Schritten des Anspruchs 6 bzw. den kennzeichnenden Merkmalen des Anspruchs 8.

## Patentansprüche

1. Vorgestanztes Metallrahmenband zur Herstellung von elektronischen Bauelementen mit Halbleiterkristallen, welches aus wenigstens zwei seitlichen, in Richtung seiner Längsachse verlaufenden Aufbaustreifen besteht, die miteinander in regelmäßigen Intervallen über querverlaufende Segmente verbunden sind, zwischen denen koplanare Zungenpaare vorgesehen sind, von denen jede Zunge in einem Stück mit einem der seitlichen Aufbaustreifen ausgebildet ist und sich in Richtung ihrer Längsachse zu dem anderen seitlichen Aufbaustreifen erstreckt, ohne die andere Zunge des betreffenden Paares zu berühren, wobei die Zungen jedes Paares im wesentlichen zueinander ausgerichtet sind, einerseits eine der Zungen jedes Paares einen freien Endabschnitt aufweist, der eine Halteaufnahme für den Halbleiterkristall bildet, und andererseits die andere Zunge jedes Paares einen auf der Höhe ihres freien Endes vorgestanzten Verbindungsteil in Form eines Metallstreifens aufweist, der so umgelegt werden kann, daß er in Kontakt mit dem Halbleiterkristall kommt, wobei er sich dann im wesentlichen in einem Volumen befindet, das von zwei zur Ebene des Metallrahmenbandes rechtwinkligen Ebenen bestimmt wird, die durch die parallel zu den Längsachsen der Zungen verlaufenden Längsränder der Zungen gehen, **dadurch gekennzeichnet, daß** die Längsachsen der beiden Zungen (5, 5') eines jeden Paares im wesentlichen koinzident sind, daß der umlegbare Verbindungsteil (8) an dem Endabschnitt der Zunge vorgestanzt ist, der auf den Halbleiterkristall gerichtet ist, daß dieser Endabschnitt freiliegend ist, daß das dem Halbleiterkristall abgewandte Ende der Zunge mit dem Aufbaustreifen verbunden ist, daß der freie distale Teil (9) eines äußeren Segments (10) in einem Kontaktbereich (15) desselben mit einer quer zu dessen Ebene verlaufenden Perforation (14) versehen ist und daß die Perforation (14) an der Fläche (9') des frelen distalen Teils (9), die nach dem Umlegen zu dem Halbleiterkristall (2) gerichtet ist, in einem Krater mündet, der eine Ringwand (16') hat, die die Perforation (14) umgibt und über die Fläche (9') des distalen Teils (9), die nach dem Umlegen zu dem Halbleiterkristall (2) gerichtet ist, vorsteht.

2. Rahmenband nach Anspruch 1, **dadurch gekennzeichnet, daß** die Perforation (14) auf der Höhe der Fläche des freien distalen Teils (9), die der Fläche (9') gegenüberliegt, welche dazu bestimmt ist, zu dem Halbleiterkristall (2') gewendet zu werden, in einer Verstärkung (17) in Form einer kreisförmigen Schale mündet.

3. Rahmenband nach Anspruch 1, **dadurch gekennzeichnet, daß** die Ringwand (16') als an der Zunge angeformte Verstärkung (17) die Perforation (14) außen umschließt.

4. Rahmenband nach einem der Ansprüche 1 bis 3, **dadurch gekennzeichnet, daß** die querverlaufenden Segmente (4) Verlängerungen (18) in Form von Fahnen aufweisen, deren freie Endabschnitte (18') in ein Volumen vorstehen, das die Verbindung zwischen den Zungen (5, 5') und dem Halbleiterkristall (2') umgibt und schließlich durch die Masse des Schutzgehäuses (19) eingenommen wird, das durch Anformen vorgesehen wird.

5. Rahmenband nach Anspruch 4, **dadurch gekennzeichnet, daß** jedes querverlaufende Segment (4) zwei Verlängerungen (18) in Form einer Fahne aufweist, die im Abstand auf jeder seiner Seiten vorgesehen sind.

6. Verfahren zum Herstellen von elektronischen Bauelementen mit Halbleiterkristallen, ausgehend von einem vorgestanzten Metallrahmenband, das aus wenigstens zwei seitlichen, in Richtung seiner Längsachse verlaufenden Aufbaustreifen besteht, die miteinander in regelmäßigen Intervallen über querverlaufende Segmente verbunden sind, zwischen denen koplanare Zungenpaare vorgesehen sind, die jeweils in einem Stück mit einem der seitlichen Aufbaustreifen ausgebildet sind und sich in Richtung ihrer Längsachsen zu dem jeweils anderen seitlichen Aufbaustreifen erstrecken, ohne die andere Zunge des betreffenden Paares zu berühren, **dadurch gekennzeichnet, daß** ein vorgestanztes Metallrahmenband mit einer ein Aufwickeln in Rollen ermöglichenden Länge nach einem der Ansprüche 1 bis 5 zugeführt wird und dafür gesorgt wird, daß es schrittweise in Längsrichtung vorgeschoben wird, währenddessen wenigstens die folgenden Arbeitsvorgänge nacheinander an jedem Zungenpaar (5, 5') ausgeführt werden:
- Anordnen des Halbleiterkristalls (2') auf einer Halteaufnahme (6), die so ausgebildet ist, daß sie sich auf der Höhe des freien Endabschnittes der ersten Zunge (5) befindet,
- Umlegen eines vorgestanzten Verbindungsteils (8) in Form eines Metallstreifens, der fest mit dem freien Ende (7) der zweiten Zunge (5') verbunden ist, und Verbinden mit dem Halbleiterkristall (2'),
- Herstellen der Verbindung des Halbleiterkristalls (2') mit der zweiten Zunge (5') nach dem Umlegen des Verbindungsteils (8) über einen mechanischen Kontakt mit einem vorstehenden Teil (9"; 16) des freien distalen Teils (9) und durch Anordnen eines leitenden schmelzbaren Bindemittels zwischen letzterem und dem Kristall (2') oder durch Einleiten eines leitenden schmelzbaren Bindemittels (20) in die Perforation (14),
- Anformen eines Schutzgehäuses (19) um den Bereich der Verbindung zwischen den Zungen (5, 5') und dem Kristall (2'),
- Abtrennen der beiden Zungen (5, 5') und Abschneiden und Formen von äußeren Anschlußfahnen und
- Messen und Prüfen der Bauelemente (2) und Aussondern von fehlerhaften Bauelementen.

7. Verfahren nach Anspruch 6, **dadurch gekennzeichnet, daß** die Masse, die das Schutzgehäuse (19) bildet, auch um die freien Enden (18') von Verlängerungen (18) in Form von Fahnen gegossen wird, die von querverlaufenden Segmenten (4) der Zungen (5, 5') ausgehen und damit fest verbunden sind, so daß das Aussondern von fehlerhaften Bauelementen (2) dadurch erfolgt, daß auf diese ein ausreichender Druck ausgeübt wird, um die Verbindung zwischen dem Gehäuse (19) und den Verlängerungen (18) in Form von Fahnen durchzubrechen.

8. Verfahren gemäß Anspruch 6 oder 7, **dadurch gekennzeichnet, daß** der vorgestanzte Verbindungsteil (8) eine vorgeformte Verlängerung (8) der Zunge ist, im wesentlichen eine L-Form hat und mit einem Zwischenverbindungssegment (11) versehen ist, das auf sich selbst umgelegt ist, und mit einem zweifach umgelegten äußeren Segment (10), dessen distaler Endabschnitt (9) in Kontakt mit der oberen Außenfläche des Halbleiterkristalls (2') über einen vorstehenden Krater steht, der die Öffnung einer quer zur Ebene des äußeren Segments verlaufenden Perforation (14) bildet, die ein leitendes Kontaktbindemittel (20) enthält, das die elektrische Verbindung sicherstellt und wenigstens teilweise mechanisch den distalen Endabschnitt (9) mit dem Halbleiterkristall (2') zusammenhält.

9. Verfahren nach Anspruch 8, **dadurch gekennzeichnet, daß** ein Abstand (d) zwischen den beiden einander gegenüberliegenden Abschnitten des zweifach umgelegten äußeren Segments im wesentlichen der Höhe des Halbleiterkristalls (2') äquivalent ist.

## Claims

1. Pre-stamped metal lead frame for producing electronic components with semiconductor crystals, which consists of at least two lateral support strips extending in the direction of its longitudinal axis, which are interconnected at regular intervals by transversely extending segments between which coplanar tongue pairs are provided, *each* tongue being formed in one piece with one of the lateral support strips and extending in the direction of its longitudinal axis toward the other lateral support strip, without contacting the other tongue of the respective pair, the tongues of each pair being oriented substantially toward each other, one of the tongues of each pair having a free end segment which forms a receptacle for the semiconductor crystal, the other tongue of each pair having a pre-stamped connecting member at the level of its free end in the form of a metal strip which can be folded over so that it comes into contact with a semiconductor crystal, whereupon it becomes located substantially within a volume which is determined by two surfaces perpendicular to the plane of the metal lead frame which extend through the edges of the tongues which are parallel to the longitudinal axes of the tongues, **characterized in that** the longitudinal axes of both tongues (5, 5') of each pair are substantially coincident, that the foldable connecting portion (8) at the end segment ofthe tongue which is oriented toward the semiconductor crystal is pre-stamped, that this end segment is free, that the end of the tongue facing away from the semiconductor crystal is connected to the support strip, that the free distal portion (9), of an outer segment (10) is provided in a contact region (15) thereof with a perforation (14) transverse to its plane and that the perforation (14) in plane (9') of the free distal portion (9) which is oriented toward the semiconductor crystal after folding over, leads into a crater which has an annular wall (16') which surrounds the perforation (14) and extends above the surface (9') of the distal portion (9) which is oriented toward the semiconductor crystal (2) after folding over.

2. Lead frame according to claim 1 **characterized in that** the perforation (14) at the level of the surface of the free distal portion (9) which faces the surface (9') which is intended to be oriented toward the semiconductor crystal (2') extends into a reinforcement (17) in the shape of a circular dish.

3. Lead frame according to claim 1 **characterized in that** the annular wall (16') ourwardly surrounds the perforation (14) by means of the reinforcement (17) which is formed on the tongue.

4. Lead frame according to one of claims 1 to 3, **characterized in that** the transversely extending segments (4) have extensions (18) in the form of tabs, whose free end portions (18') extend into a space which surrounds the connection between the tongues (5, 5') and the semiconductor crystal (2') and are further contained in the body of the protective housing (19) which is molded-on.

5. Lead frame according to claim 4, **characterized in that** each transversely extending segment (4) has two extensions (18) in the form of a tab, which is provided spaced-apart on each of its sides.

6. Method for producing electronic components with semiconductor crystals starting from a pre-stamped lead frame which consists of at least two lateral support strips extending in the direction of its longitudinal axis, which are connected at regular intervals by transversely extending segments between which coplanar tongue pairs are provided, which are formed respectively in one piece with one of the lateral support strips and which extend respectively in their longitudinal directions toward the other lateral support strip, without touching the other tongue of the respective pair, **characterized in that** there is provided a pre-stamped lead frame according to any one of claims 1 to 5 and having a length which enables it to be rolled up, taking care that it is advanced step by step in the longitudinal direction while at least the following manufacturing steps are carried out consecutively at each tongue pair (5, 5'):
-- placing the semiconductor crystal (2') on a holder (6) which is so constructed that it is located at the level of the free end segment of the first tongue (5).
-- folding over one pre-stamped connecting portion (8) in the form of a metal strip which is firmly connected to the free end (7) of the second tongue (5'), and connecting to the semiconductor crystal (2'),
-- creating the connection of the semiconductor crystal (2') to the second tongue (5'), after folding over of the connecting portion (8), by means of a mechanical contact with an extending portion (9"), of the free distal portion (9) and by introducing a conductive fusible connecting means between the latter and the crystal (2'), or by introducing a conductive fusible connecting means (20) into the perforation (14),
-- molding-on a protective housing (19) around the region of the connection between the tongues (5, 5') and the crystal (2'),
-- separating the two tongues (5, 5') and severing and forming the outer connecting tabs and
-- measuring and testing the structural elements (2) and separating defective components.

7. Method according to claim 6, **characterized in that** the mass which forms the protective housing (19) is also molded around the free ends (18') of extensions (18) having the form of tabs, which extend out from transversely extending segments (4) of the tongues (5, 5') and are firmly connected thereto, so that the separation of defective components (2) takes place by applying sufficient pressure to them to break the connection between the housing (19) and the extensions (18) which are in the form of tabs.

8. Method according to claim 6 or 7, **characterized in that** the pre-stamped connecting portion is a preformed extension (8) of the tongue, has essentially an L-shape and is provided with an intermediate connecting segment (11) which is folded over on itself and has a doubly folded-over outer segment (10) whose distal end segment (9) is in contact with the upper outer surface of semiconductor crystal (2') via a protruding crater which forms the opening of a perforation (14) which extends transversely to the plane of the outer segments, which contains a conductive contact maintaining means (20) which assures the electrical connection and holds together the distal end segment with the semiconductor crystal (2') at least partly mechanically.

9. Method according to claim 8, **characterized in that** a distance (d) between the two opposing segments of the doubly folded-over outer segment is substantially equal to the height of the semiconductor crystal (2').

## Revendications

1. Structure métallique prédécoupée destinée à la réalisation de composants électroniques intégrant des cristaux semi-conducteurs, et constituée d'au moins deux bandes latérales courant dans le sens longitudinal reliées entre elles à intervalles réguliers par des segments transversaux entre lesquels sont disposées des paires de languettes coplanaires, chaque languette faisant corps avec l'une des bandes latérales en s'étendant dans l'axe longitudinal pour rejoindre la bande latérale opposée mais sans jamais entrer en contact avec la languette homologue de la paire, les deux languettes de chaque paire étant ainsi orientées l'une vers l'autre, l'une des deux languettes présentant une extrémité libre formant réceptacle pour le cristal semi-conducteur, la seconde languette présentant à hauteur de son extrémité libre un élément de liaison prédécoupé sous la forme d'une lamelle métallique pouvant être déplacée pour entrer en contact avec le cristal semi-conducteur et se trouvant alors dans un volume constitué par deux plans perpendiculaires au plan de la structure métallique, passant par les bords longitudinaux des languettes parallèlement à l'axe longitudinal des languettes, **caractérisée en ce que** les axes longitudinaux des deux languettes (5, 5') de chaque paire coïncident, l'élément de liaison mobile (8) est prédécoupé à l'extrémité de la languette orientée vers le cristal semi-conducteur, cette extrémité est dégagée, l'extrémité de la languette tournée vers le cristal semi-conducteur est reliée à la structure de support, l'extrémité libre distale (9) d'un segment extérieur (10) est pourvue d'une perforation (14) courant en travers du plan de ce segment, dans une zone de contact (15) dudit segment et en ce que la perforation (14) ménagée sur la surface (9') de l'extrémité libre distale (9), orientée vers le cristal semi-conducteur (2) après déplacement, débouche sur un cratère muni d'une paroi annulaire (16') entourant la perforation (14) et faisant saillie au-dessus de la surface (9') de l'extrémité distale (9) orientée vers le cristal semi-conducteur (2) après déplacement.

2. Structure selon la revendication 1, **caractérisée en ce que** la perforation (14), à hauteur de la surface de l'extrémité libre distale (9) opposée à la surface (9') destinée à être tournée vers le cristal semi-conducteur (2'), débouche sur un renfort (17) sous la forme d'une coupelle circulaire.

3. Structure suivant la revendication 1, **caractérisée en ce que** la paroi annulaire (16') entoure la perforation (14) de l'extérieur sous la forme d'un renfort (17) formé au niveau de la languette.

4. Structure selon l'une des revendications 1 à 3, **caractérisée en ce que** les segments transversaux (4) présentent des prolongements (18) en drapeau dont les extrémités libres (18') se trouvent dans un volume entourant la liaison entre les languettes (5, 5') et le cristal semi-conducteur (2'), et finalement inclus dans la masse du boîtier de protection (19) moulé.

5. Structure suivant la revendication 4, prévoyant que chaque segment transversal (4) présente deux prolongements (18) en drapeau à une certaine distance de chaque côté.

6. Procédé de fabrication de composants électroniques intégrant des cristaux semiconducteurs à partir d'une structure métallique prédécoupée constituée d'au moins deux bandes latérales courant dans le sens longitudinal reliées entre elles à intervalles réguliers par des segments transversaux entre lesquels sont disposées des paires de languettes coplanaires, chaque languette faisant corps avec l'une des bandes latérales en s'étendant dans l'axe longitudinal pour rejoindre la bande latérale opposée mais sans jamais entrer en contact avec la languette homologue de la paire, et faisant intervenir la séquence d'opérations listées ci-dessous sur chaque paire de languettes (5, 5') de la structure métallique prédécoupée selon les dispositions envisagées aux revendications 1 à 5, montée sur un enrouleur à partir duquel elle est dévidée pas à pas en longueur :
- Disposition du cristal semi-conducteur (2') sur un réceptacle (6) ménagé à la hauteur de l'extrémité de la première languette (5),
- Déplacement d'un élément de liaison (8) prédécoupé se présentant sous la forme d'une lamelle métallique fixée de manière permanente à l'extrémité libre (7) de la deuxième languette (5') en vue d'entrer en contact avec le cristal semi-conducteur (2'),
- Réalisation de la liaison entre le cristal semi-conducteur (2') et la seconde languette (5') après déplacement de l'élément de liaison (8) par un contact mécanique vers la section en saillie (9', 16) de l'extrémité libre distale (9) par application d'un produit adhésif conducteur fusible entre l'extrémité libre distale et le cristal semi-conducteur (2') ou par insertion d'un produit adhésif conducteur fusible (20) dans la perforation (14),.
- Formage d'un boîtier de protection (19) autour de la zone de la liaison entre les languettes (5, 5') et le cristal semi-conducteur (2'),
- Séparation des deux languettes (5, 5'), découpe et formage des prolongements en drapeau extérieurs
- Mesure et contrôle des composants (2) et mise à l'écart des éléments défectueux.

7. Procédé selon la revendication 6, **caractérisé en ce que** la masse constituée par le boîtier de protection (19) est coulée autour des extrémités libres (18') des prolongements (18) en drapeau issus des segments transversaux (4) des languettes (5, 5') pour en assurer la cohésion et de manière à permettre la séparation des éléments éventuellement défectueux (2) par l'application d'une pression suffisante pour casser la liaison rendant le boîtier (19) solidaire des prolongements (18) en drapeau.

8. Procédé suivant l'une des revendications 6 ou 7, **caractérisé en ce que** l'élément de liaison (8) prédécoupé est constitué par un prolongement (18) préformé de la languette, en forme de L, doté d'un segment de jonction intermédiaire (11) replié sur lui-même et disposé au-dessus d'un cratère avec un segment extérieur (10) plié en U dont l'extrémité libre distale (9) est en contact avec la surface externe supérieure du cristal semi-conducteur (2'), ledit cratère constituant l'ouverture d'une perforation (14) transversale par rapport au plan du segment extérieur, et contenant un produit adhésif conducteur (20) assurant la connexion électrique et, en partie, la cohésion mécanique entre l'extrémité distale (9) et le cristal semi-conducteur (2').

9. Procédé selon la revendication 8, **caractérisé en ce que** l'écartement (d) entre les deux branches du segment extérieur plié en U est plus ou moins équivalent à la hauteur du cristal semi-conducteur (2').
